(19) Europäisches Patentamt
European Patent Office
Office européen des brevets

(11) EP 2 423 248 A1

(12) EUROPEAN PATENT APPLICATION
published in accordance with Art. 153(4) EPC

(43) Date of publication:
29.02.2012 Bulletin 2012/09

(21) Application number: 10767142.2

(22) Date of filing: 16.04.2010

(51) Int Cl.:
*C08J 5/18* (2006.01) *H01L 31/042* (2006.01)

(86) International application number:
PCT/JP2010/057198

(87) International publication number:
WO 2010/123087 (28.10.2010 Gazette 2010/43)

(84) Designated Contracting States:
AT BE BG CH CY CZ DE DK EE ES FI FR GB GR HR HU IE IS IT LI LT LU LV MC MK MT NL NO PL PT RO SE SI SK SM TR

(30) Priority: 23.04.2009 JP 2009105058

(71) Applicant: Teijin Dupont Films Japan Limited
Chiyoda-ku
Tokyo 100-0013 (JP)

(72) Inventors:
- MATSUMURA Naoko
Anpachi-gun
Gifu 503-0123 (JP)
- OYAMATSU Atsushi
Anpachi-gun
Gifu 50-30123 (JP)

(74) Representative: Cockerton, Bruce Roger
Carpmaels & Ransford
One Southampton Row
London WC1B 5HA (GB)

# (54) BIAXIALLY STRETCHED POLYESTER FILM FOR SOLAR BATTERY

(57) A biaxially oriented polyester film for solar cells which is made of a composition of a polyethylene terephthalate prepared by using an antimony compound and/or a titanium compound as a polycondensation catalyst(s), wherein
the composition contains 10 to 80 mmol% of a phosphorus atom derived from specific phosphonic acid or specific phosphinic acid and 2 to 60 mmol% of the total of an antimony atom and/or a titanium atom as metal atoms based on the number of moles of all dicarboxylic acid components constituting the polyethylene terephthalate, the biaxially oriented polyester film has a plane orientation coefficient "fn" of 0.160 to 0.175, and the polyester of the film has an intrinsic viscosity number of 0.56 to 0.74 dl/g and a terminal carboxyl group concentration of 6 to 29 equivalents/ton.

EP 2 423 248 A1

## Description

TECHNICAL FIELD

The present invention relates to a biaxially oriented polyester film for solar cells which is inexpensive and has excellent hydrolysis resistance.

BACKGROUND ART

Polyester films, especially polyethylene terephthalate biaxially oriented films have been widely used as they are excellent in productivity, mechanical properties, thermal properties, electrical properties, chemical properties and dimensional stability. However, most polyester films have a problem that when they are used in a high-temperature high-humidity environment, they are apt to deteriorate in physical properties due to the hydrolysis of the polyester, whereby their use periods and conditions are limited.

In recent years, the improvement of long-term reliability has been desired for their use in solar cells which are used in a harsh natural environment, and when a polyester film is used as a solar cell protective film, it must be provided with excellent hydrolysis resistance.

To improve the hydrolysis resistance of a polyester film, various proposals have been made heretofore. JP-A 2007-302878 discloses a polyester film which comprises an epoxylated fatty acid alkyl ester or an epoxylated fatty acid glycerin ester as a hydrolysis resisting agent. However, in this proposal, the hydrolysis resisting agent has low reactivity, so that the effect of improving the hydrolysis resistance of the polyester film is small.

JP-A 2002-187965 discloses a polyester film which comprises a monomer or polymer of a carbodiimide compound or an oxazoline compound as a hydrolysis resisting agent. However, a film comprising a carbodiimide compound or the like causes the occurrence of a health hazard due to the stimulation of a mucosal membrane by a gas generated from an isocyanate, other by-product and a decomposed product in its production process or during its use. Further, when these hydrolysis resisting agents are used, the viscosity of the polymer rises, thereby causing problems such as extrusion instability and control difficulty in the extrusion step.

Attempts have been made to improve the hydrolysis resistance of even a polyester film used as a solar cell protective film because the hydrolysis resistance is unsatisfactory when the film is used for a long time, and it is proposed to use a high-molecular weight polyethylene terephthalate film (refer to JP-A 2002-26354) or a polyethylene terephthalate film having a low content of an oligomer (refer to JP-A 2002-100788, JP-A 2002-134770 and JP-A 2002-134771). Although the hydrolysis resistance is improved by these technologies as compared with the prior art, it is difficult to produce the film efficiently. Therefore, these technologies are not practical means from the industrial point of view.

It is also proposed to use a polyester film comprising a 2,6-naphthalenedicarboxylic acid component (refer to JP-A 2007-007885 and JP-A 2006-306910). However, although this film has excellent hydrolysis resistance, it is greatly discolored by ultraviolet radiation and more expensive than a polyethylene terephthalate film, and its use as a member of a solar cell is limited.

DISCLOSURE OF THE INVENTION

The present invention has been made in view of the above problems. It is a first object of the present invention to provide a biaxially oriented polyester film for solar cells which rarely deteriorates in mechanical properties and has excellent hydrolysis resistance even when it is used in a high-temperature high-humidity harsh natural environment for a long time. It is a second object of the present invention to provide a biaxially oriented polyester film for solar cells which has excellent hydrolysis resistance without using a hydrolysis resisting agent such as a carbodiimide compound or an oxazoline compound.

The inventors of the present invention have conducted intensive studies to solve the above problems of the prior art, have found that the problems can be solved by the following means and have arrived at the present invention.

That is, the present invention is a biaxially oriented polyester film for solar cells which is made of a composition of a polyethylene terephthalate prepared by using an antimony compound and/or a titanium compound as a polycondensation catalyst (s), wherein the composition contains 10 to 80 mmol% of a phosphorus atom derived from a phosphorus compound represented by the following formula (I) or (II) and 2 to 60 mmol% of the total of an antimony atom and/or a titanium atom as metal atoms based on the moles of all dicarboxylic acid components constituting the polyethylene terephthalate, the biaxially oriented polyester film has a plane orientation coefficient "fn" of 0.160 to 0.175, and the polyester of the film has an intrinsic viscosity number of 0.56 to 0.74 dl/g and a terminal carboxyl group concentration of 6 to 29 equivalents/ton.

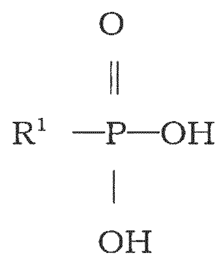 (I)

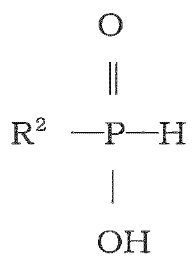 (I I)

wherein, each of $R^1$ and $R^2$ is independently an alkyl group having 1 to 6 carbon atoms, aryl group or benzyl group.

BEST MODE FOR CARRYING OUT THE INVENTION

The present invention will be described in detail hereinunder.

[polyethylene terephthalate]

The biaxially oriented polyester film for solar cells of the present invention is made of a composition comprising a polyethylene terephthalate polymerized by using an antimony compound and/or a titanium compound as a polycondensation catalyst(s). The polyethylene terephthalate of this composition is a polyester comprising ethylene terephthalate as the main recurring unit. The expression "ethylene terephthalate as the main recurring unit" means that the ethylene terephthalate unit accounts for preferably not less than 90 mol%, more preferably not less than 95 mol%, much more preferably not less than 97 mol% of the total of all the recurring units constituting the polyester.

When the ethylene terephthalate unit accounts for less than 90 mol% of the total of all the recurring units of the polyethylene terephthalate, heat resistance degrades and it is difficult to set the plane orientation coefficient "fn" to 0.16 to 0.175 with the result that the hydrolysis resistance of the film deteriorates.

The polyethylene terephthalate may be prepared by copolymerizing a comonomer component as long as the ethylene terephthalate unit is the main recurring unit. The comonomer component may be either a dicarboxylic acid component or a diol component. Examples of the dicarboxylic acid component as the comonomer component include aromatic dicarboxylic acids such as isophthalic acid, phthalic acid and naphthalenedicarboxylic acid; aliphatic dicarboxylic acids such as adipic acid, azelaic acid, sebacic acid and decanedicarboxylic acid; and alicyclic dicarboxylic acids such as cyclohexanedicarboxylic acid. Examples of the diol component as the comonomer component include aliphatic diols such as butanediol and hexanediol; and alicyclic diols such as cyclohexanedimethanol. These comonomer components may be used alone or in combination of two or more.

[phosphorus compound]

The composition of the polyethylene terephthalate constituting the biaxially oriented polyester film for solar cells of the present invention contains 10 to 80 mmol%, preferably 15 to 75 mmol% of a phosphorus atom derived from a phosphorus compound represented by the following formula (I) or (II) based on the moles of all the dicarboxylic acid components constituting the polyethylene terephthalate.

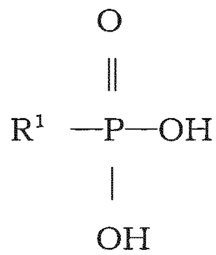

(I)

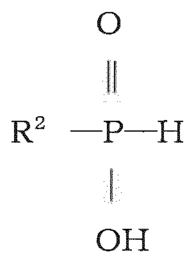

(II)

wherein, each of $R^1$ and $R^2$ is independently an alkyl group, aryl group or benzyl group.

Examples of the phosphorus compound represented by the formula (I) include methylphosphonic acid, ethylphosphonic acid, propylphosphonic acid, isopropylphosphonic acid, butylphosphonic acid, phenylphosphonic acid, tolylphosphonic acid, xylylphosphonic acid and benzylphosphonic acid. Out of these, phenylphosphonic acid is preferred.

Examples of the phosphorus compound represented by the formula (II) include methylphosphinic acid, ethylphosphinic acid, propylphosphinic acid, isopropylphosphinic acid, butylphosphinic acid, phenylphosphinic acid, tolylphosphinic acid, xylylphosphinic acid and benzylphosphinic acid. Out of these, phenylphosphinic acid is preferred.

When the content of the phosphorus atom derived from the phosphorus compound represented by the formula (I) or (II) is lower than 10 mmol% based on the number of moles of all the dicarboxylic acid components constituting the polyethylene terephthalate, the crystallinity of the obtained polyester film becomes unsatisfactory and inferior in hydrolysis resistance. When the content is higher than 80 mmol%, the effect is saturated, which is uneconomical, and hydrolysis resistance degrades.

[antimony atom and/or titanium atom]

Since the biaxially oriented polyester film for solar cells of the present invention contains a phosphorus atom derived from a specific phosphorus compound and an antimony atom derived from an antimony compound used as a polycondensation catalyst and/or a titanium atom derived from a titanium compound used as a polycondensation catalyst, the crystallinity of the obtained film improves, thereby obtaining high hydrolysis resistance.

The composition of the polyethylene terephthalate constituting the biaxially oriented polyester film for solar cells of the present invention contains 2 to 60 mmol%, preferably 10 to 50 mmol% of the total of the antimony atom and/or the titanium atom in terms of metal atoms. When the total content of these metals is lower than 2 mmol%, the polycondensation reaction speed becomes too slow, thereby reducing the productivity of the polyester raw material and making it impossible to obtain a crystalline polyester having a required intrinsic viscosity number with the result of the deteriorated hydrolysis resistance of the film. When the total content is higher than 60 mmol%, an excessive amount of the polycondensation catalyst exists in the film, thereby reducing the hydrolysis resistance of the film or enhancing the coloring of the film.

As the antimony compound may be used an organic antimony compound such as antimony oxide, antimony chloride or antimony acetate, out of which antimony oxide or antimony acetate is preferred. These antimony compounds may be used alone or in combination.

As the titanium compound may be used a titanium compound which is generally known as a polycondensation catalyst for polyesters, such as titanium acetate or tetra-n-butoxytitanium.

[plane orientation coefficient of film]

The biaxially oriented polyester film for solar cells of the present invention has a plane orientation coefficient "fn" of 0.160 to 0.175, preferably 0.163 to 0.173. When "fn" is smaller than 0.160, the hydrolysis resistance of the film becomes unsatisfactory and when "fn" is larger than 0.175, film formation becomes unstable, which is not practical from

the industrial point of view.

In the present invention, the plane orientation coefficient "fn" is obtained from the refractive index of the film measured with an Abbe refractometer which will be described hereinafter.

To set the plane orientation coefficient "fn" of the film to a range of 0.160 to 0.175, it is recommended to adjust the content of the ethylene terephthalate unit of the polyester of the film to not less than 90 mol%, the draw ratios in a lengthwise direction (to be referred to as "longitudinal direction" hereinafter) and a direction orthogonal to the longitudinal direction (to be referred to as "transverse direction" hereinafter) to 2.8 to 4.5 times, the area draw ratio obtained by multiplying the draw ratio in the longitudinal direction by the draw ratio in the transverse direction to not less than 10 times, and the heat setting temperature after stretching in the transverse direction to a range of (Tm-20˚C) to (Tm-60˚C).

[intrinsic viscosity number]

It is important that the intrinsic viscosity number of the polyester of the biaxially oriented polyester film for solar cells of the present invention should be 0.56 to 0.74 dl/g. When the intrinsic viscosity number is smaller than 0.56 dl/g, the hydrolysis resistance of the film becomes unsatisfactory. To form a polyester film having an intrinsic viscosity number of more than 0.74 dl/g, a polyester raw material having a higher polymerization degree is required. To this end, a long polymerization time is needed, and the production efficiency does not rise due to the high melt viscosity of the raw material even in the production process of the film, resulting in diseconomy.

To set the intrinsic viscosity number of the polyester of the film to 0.56 to 0.74 dl/g, the intrinsic viscosity number of the raw material polyester to be used for the formation of a film should be set to 0.60 to 0.90 dl/g, preferably 0.65 to 0.85 dl/g.

The intrinsic viscosity number of the polyester of the film is the intrinsic viscosity number of a film sample, and the intrinsic viscosity number of the raw material polyester is the intrinsic viscosity number of a pellet sample to be supplied into an extruder. These intrinsic viscosity numbers are obtained from measurement values measured at 35˚C after the sample is dissolved in a mixed solvent of phenol and tetrachloroethane in a weight ratio of 6:4.

[terminal carboxyl group concentration]

The terminal carboxyl group concentration of the polyester of the biaxially oriented polyester film for solar cells of the present invention is 6 to 29 equivalents/ton, preferably 6 to 24 equivalents/ton, more preferably 6 to 20 equivalents/ton. When the terminal carboxyl group concentration is higher than 29 equivalents/ton, the hydrolysis resistance of the film degrades and the physical properties of the film are apt to deteriorate disadvantageously when it is used at a high temperature and a high humidity for a long time. To obtain a film having a terminal carboxyl group concentration of less than 6 equivalents/ton, a polyester raw material having a lower terminal carboxyl group concentration than the above range must be used with the result of the prolonged polymerization time of the raw material polyester, which is uneconomical.

[additives]

An oxazoline compound and/or a carbodiimide compound may be added to the composition of the polyethylene terephthalate in the biaxially oriented polyester film for solar cells of the present invention in order to provide higher hydrolysis resistance as long as the effect of the present invention is not impaired.

A lubricant may be added to the composition of the polyethylene terephthalate in the biaxially oriented polyester film for solar cells of the present invention to obtain a smooth surface so as to improve its handling properties. The lubricant maybe either organic or inorganic . Examples of the inorganic lubricant include titanium oxide, barium sulfate, calcium carbonate, silicon dioxide and alumina particles. They may be either lamellar or spherical. From the viewpoints of dispersibility and slipperiness, the average particle diameter of the particles is preferably 0 .1 to 5.0 μm, more preferably 0.2 to 4.0 μm.

The biaxially oriented polyester film for solar cells of the present invention may optionally contain conventionally known additives such as an antioxidant, ultraviolet absorbent, antistatic agent and flame retardant. A hindered phenol-based compound may be used as the antioxidant, and a benzotriazole-based compound or a triazine-based compound may be used as the ultraviolet absorbent.

The biaxially oriented polyester film for solar cells of the present invention may be colored as required. For example, it may be colored white, black or blue. When it is colored white and used as a protective film for the rear surface of a solar cell, it can increase the reflection of sunlight on the film surface, thereby raising the conversion efficiency of the solar cell. When it is colored black or blue, a film suitable for the design of a building in the construction field where importance is attached to design can be provided.

The biaxially oriented polyester film for solar cells of the present invention may comprise a coating layer

containing a lubricant, additives and a colorant. The biaxially oriented polyester film for solar cells of the present invention may be composed of multiple layers at least one of which contains a lubricant, additives and a colorant.

[hydrolysis resistance]

Preferably, the biaxially oriented polyester film for solar cells of the present invention has an elongation retention of not less than 50 % after it is aged in an environment having a temperature of 85˚C and a humidity of 85 %RH for 3,000 hours. 3,000 hours of aging in an environment having a temperature of 85˚C and a humidity of 85 %RH is almost equivalent to 30 years of outdoor weathering. When the film has this elongation retention, it hardly deteriorates and does not degrade in physical properties for a long time after it is used outdoors for a long time.

[film thickness, coating layer]

The thickness of the biaxially oriented polyester film for solar cells of the present invention is preferably 20 to 350 μm, more preferably 40 to 250 μm, particularly preferably 50 to 200 μm. When the thickness falls within this range, good handling properties and film formability can be obtained.

To fabricate a solar cell by using the biaxially oriented polyester film for solar cells of the present invention, a sealing resin for solar cell elements is formed on the polyester film. In this case, an adhesive coating may be applied to one side of the polyester film of the present invention in order to improve adhesion between the polyester film and the sealing resin.

The material of the coating layer is preferably a material which shows excellent adhesion to both the polyester film and EVA (ethylene vinyl acetate). As the material may be used a polyester resin or an acrylic resin. Preferably, these resins further contain a crosslinking component. A commonly known coating method may be employed. An in-line coating method in which an aqueous solution containing the constituent components of the above coating layer is applied to a stretchable polyester film, dried, stretched and heated is preferred. At this point, the thickness of the coating layer formed on the polyester film is preferably 0.01 to 1 μm.

[solar cell protective film]

The biaxially oriented polyester film for solar cells of the present invention can be advantageously used as a rear surface protective film for solar cells. In this case, it may be laminated with another film before use. For example, in order to improve insulating properties, it may be laminated with another polyester film to obtain a laminate, and in order to improve durability, it may be laminated with a film of a high-weatherability resin such as polyvinyl fluoride to obtain a laminate.

When the biaxially oriented polyester film for solar cells of the present invention is used as a rear surface protective film for solar cells, a water vapor barrier layer may be laminated with the polyester film to provide water vapor barrier properties. The solar cell protective film having this configuration preferably has a water vapor permittivity measured in accordance with JIS Z0208-73 of not more than 5 g/ ($m^2$. 24h).

As the water vapor barrier layer may be used a film or foil, or a coating layer or deposited thin film layer of an inorganic oxide having water vapor barrier properties. Examples of the film having water vapor barrier properties include a vinylidene polychloride film, vinylidene polychloride coated film, vinylidene polyfluoride coated film, silicon oxide deposited film, aluminum oxide deposited film and aluminum deposited film. Examples of the foil include an aluminum foil and copper foil. When a coating layer or deposited thin film layer of an inorganic oxide is used, the layer can be formed directly on the biaxially oriented polyester film for solar cells of the present invention by coating or deposition.

The water vapor barrier layer may be formed on a side opposite to the EVA adhesion side of the polyester film of the present invention. Further, another resin film may be formed on the exterior side of the water vapor barrier layer to sandwich the water vapor barrier layer between a plurality of films so as to obtain a rear surface protective film for solar cells.

[method of producing polyethylene terephthalate]

An example of the method of producing the composition of the polyethylene terephthalate which is used as a raw material for forming the biaxially oriented polyester film for solar cells of the present invention will be described hereinunder. The polyethylene terephthalate is obtained by carrying out a polycondensation reaction after dimethyl terephthalate and ethylene glycol are subjected to a transesterification reaction. In this production process, after the transesterification reaction is carried out while the formed alcohol is removed, a phosphorus compound is added to terminate the transesterification reaction substantially and then, an antimony compound and/or a titanium compound are/is added to the obtained reaction product to carry out a polycondensation reaction. A pellet of the obtained polyethylene terephthalate is subjected to solid-phase polymerization to obtain a composition of the polyethylene terephthalate having a terminal carboxyl group concentration of 6 to 29 equivalents/ton.

The glass transition temperature and melting point of the polyethylene terephthalate will be represented by "Tg" and "Tm" hereinafter, respectively.

To control the terminal carboxyl group concentration of the polyethylene terephthalate to this range, a polyethylene terephthalate having an intrinsic viscosity number of 0.50 to 0.58 and a terminal carboxyl group concentration of 10 to 40 equivalents/ton is polymerized and then subjected to so-called "solid-phase polymerization" by heating at a temperature of (Tm-50˚C) or higher and lower than Tm under reduced pressure or in an atmosphere of an inert gas such as nitrogen gas. This solid-phase polymerization can raise the intrinsic viscosity number of the raw material polyester to 0.60 to 0.90 dl/g without increasing the terminal carboxyl group concentration of the raw material polyester.

[method of producing a film]

The biaxially oriented polyester film for solar cells of the present invention can be produced, for example, by the following method in accordance with a conventionally known film forming method.

The raw material polyethylene terephthalate is first melt extruded into a film form from a slit die and solidified by cooling with a casting drum to obtain an unstretched film which is then stretched in at least a monoaxial direction, preferably biaxial directions. Stretching may be either sequential biaxial stretching or simultaneous biaxial stretching.

In the case of sequential biaxial stretching, for example, the unstretched film is heated with rolls or by infrared radiation to be stretched in a longitudinal direction so as to obtain a longitudinally stretched film. This stretching is preferably carried out by making use of the difference between the rolling speeds of two or more rolls. The stretching temperature is a temperature equal to or higher than Tg of the polyester, more preferably Tg to (Tg+70˚C). The film which has been stretched in the longitudinal direction is then stretched in a transverse direction, heat set and thermally relaxed to obtain a biaxially oriented film. These steps are preferably carried out while the film is travelling. Stretching in the transverse direction starts from a temperature higher than Tg. Then, the temperature is preferably raised up to (Tg+50˚C) to (Tg+70˚C). The temperature may be raised continuously or stepwise (sequentially) in the step of stretching in the transverse direction. In general, the temperature is preferably raised sequentially. For example, the transverse stretching zone of a tenter is divided into a plurality of sections in the traveling direction of the film so that a heating medium having a predetermined temperature is caused to flow into each of the sections to raise the temperature.

The draw ratio is preferably 2.5 to 4.5 times in both longitudinal and transverse directions. When the draw ratio falls within this range, a film having little thickness nonuniformity can be obtained without being broken during film formation. To obtain high productivity, it is preferred that the line speed should not be kept low, the draw ratio in the longitudinal direction should be set to 3.2 to 4.5 times, and the draw ratio in the transverse direction should be set to 2.8 to 4.2 times.

The film which has been stretched in the transverse direction is preferably heated at (Tm-20˚C) to (Tm-60˚C) while both ends of the film are held with a fixed width or a width reduction of not more than 10 % to reduce the heat shrinkage factor of the film. Thereby, the dimensional stability of the film is improved. When the film is heated at a higher temperature than this, the flatness of the film degrades and the thickness nonuniformity of the film becomes large disadvantageously. When the film is heated at a temperature lower than (Tm-60˚C), the heat shrinkage factor may become large. Further, to adjust the amount of heat shrinkage at (Tm-20˚C) to (Tm-60˚C), the both ends of the film held are cut off when the film temperature is returned to normal temperature after heat setting, and the take-off speed in the longitudinal direction of the film is adjusted, thereby making it possible to relax the film in the longitudinal direction (refer to JP-A 57-57628). The means of relaxing the film is to adjust the speeds of rolls on the exit side of the tenter. As for relaxation ratio, the speeds of the rolls are reduced with respect to the film line speed of the tenter by preferably 0.1 to 1.5 %, more preferably 0.2 to 1.2 %, particularly preferably 0.3 to 1.0 so as to relax the film (this value is called "relaxation ratio"). Thus, the heat shrinkage factor in the longitudinal direction of the film is adjusted by controlling the relaxation ratio. As an alternative method, a relaxation heat treatment is carried out while the film is suspended as disclosed by JP-A 1-275031. To enhance the dimensional stability in the transverse direction of the film, a desired heat shrinkage factor can be obtained by reducing the width of the film before the both ends of the film are cut off.

Examples

The following examples are provided to further illustrate the present invention. Evaluations were made by the following methods.

(1) Film thickness

The thickness of a film sample was measured at 10 points with an electric micrometer (K-402B of Anritsu

Corporation) to obtain the average value of the measurement data as film thickness.

(2) Intrinsic viscosity number (IV)

A value was calculated from the viscosity of a solution prepared by dissolving the sample in a mixed solvent of phenol and tetrachloroethane in a weight ratio of 6:4 measured at 35˚C based on the following formula.

$$\eta_{sp}/C = [\eta] + K[\eta]^2 \cdot C$$

In the above formula, $\eta_{sp}$ = (solution viscosity/solvent viscosity) - 1, C is the weight (g/100 ml) of the molten polymer based on 100 ml of the solvent, and K is a Huggins constant. The solution viscosity and the solvent viscosity were measured with an Ostwald viscometer. The unit is [dl/g].

(3) Plane orientation coefficient "fn"

This was measured by using sodium D line (wavelength of 589 nm) as a light source and an Abbe refractometer. The plane orientation coefficient "fn" was calculated from the refractive index in the longitudinal direction (Nx), the refractive index in the transverse direction (Ny) and the refractive index in the thickness direction (Nz) of the film based on the following formula.

$$fn = (Nx + Ny)/2 - Nz$$

(4) Terminal carboxyl group concentration

10 mg of the sample was dissolved in 0.5 ml of a mixed solvent of HFIP (hexafluoroisopropanol) and heavy chloroform in a weight ratio of 1:3 and a few drops of isopropylamine were added to the resulting solution to determine the quantity of the terminal carboxyl group by $^1$H-NMR (50˚C, 600 MHz).

(5) Hydrolysis resistance

A oblong-shaped film sample having a length of 100 mm and a width of 10 mm was left in an environmental tester set at a temperature of 85˚C and a humidity of 85 %RH for 3,000 hours. Then, the sample was taken out, and the fracture elongation in the longitudinal direction of the sample was measured 5 times to obtain the average value of the measurement data. A value obtained by dividing the average value by the measurement value of fracture elongation before the sample was left is taken as an Elongation retention at break (%) to evaluate the hydrolysis resistance of the sample based on the following criteria. As the Elongation retention at break becomes higher, the hydrolysis resistance becomes better.

$$\text{Fracture elongation retention (\%)} = (\text{fracture elongation after 3,000 hours of treatment})/(\text{fracture elongation before treatment}) \times 100$$

◎: Elongation retention at break of not less than 70 %
○ Elongation retention at break of not less than 50 % and less than 70 %
△: Elongation retention at break of not less than 30 % and less than 50 %
×: Elongation retention at break of less than 30 %

(6) Melt extrudability

Extrudability was evaluated based on the following criteria.

○: extrusion is easy
×: extrusion load is high and film formation takes long and is costly

(7) Film formability

The sample was stretched in longitudinal and transverse directions to form a film so as to check if film formation can be made stably based on the following criteria.

○: film formation can be made stably for 2 hours or longer
△: film splits in 10 minutes or longer and less than 2 hours
×: film splits in less than 10 minutes and stable film formation is impossible

Reference Example 1

production of polyethylene terephthalate (PET-a)

100 parts by weight of dimethyl terephthalate, 60 parts by weight of ethylene glycol and 30 mmol% of a manganese acetate tetrahydrate salt (based on the number of moles of dimethyl terephthalate) were fed to a transesterification reactor, heated at 150 ˚C to be molten and stirred. The inside temperature of the reactor was gradually raised up to 235˚C to promote the reaction, and the formed methanol was distilled off to the outside of the reactor. After the end of the distillation-off of methanol, phenylphosphonic acid was added to terminate the transesterification reaction. Thereafter, the reaction product was transferred to a polymerizer, and antimony oxide as a polymerization catalyst was added. Then, the inside temperature of the polymerizer was raised from 235˚C to 290˚C over 90 minutes and the inside pressure of the polymerization was reduced from the atmospheric pressure to 100 Pa over 90 minutes at the same time. After the agitation torque of the content of the polymerizer reached a predetermined value, the inside pressure of the polymerizer was returned to the atmospheric pressure with a nitrogen gas to terminate the polymerization. A valve at a lower portion of the polymerizer was opened to increase the inside pressure of the polymerizer with a nitrogen gas so as to discharge polymerized polyethylene terephthalate into water as a strand. The strand was cut into chips with a cutter. Thus, the polyethylene terephthalate polymer having an intrinsic viscosity number of 0.64 dl/g and a terminal carboxyl group concentration of 17 equivalents/ton was obtained. The amounts of antimony oxide and the phosphorus compound added as polymerization catalysts (based on the number of moles of dimethyl terephthalate) are shown in Table 1. The obtained polyester is designated as "PET-a".

Reference Example 2

production of polyethylene terephthalate (PET-b)

After the polymer (PET-a) obtained in Reference Example 1 was pre-dried at 150˚C to 160˚C for 3 hours, the solid-phase polymerization of the polymer was carried out in a nitrogen gas atmosphere at 210˚C and 100 Torr for 7 hours. The polymer after solid-phase polymerization had an intrinsic viscosity number of 0.82 dl/g and a terminal carboxyl group concentration of 10 equivalents/ton. This polymer is designated as "PET-b".

Reference Example 3

production of polyethylene terephthalate (PET-c)

After the polymer (PET-a) obtained in Reference Example 1 was pre-dried at 150˚C to 160˚C for 3 hours, the solid-phase polymerization of the polymer was carried out in a nitrogen gas atmosphere at 210˚C and 100 Torr for 12 hours. The polymer after solid-phase polymerization had an intrinsic viscosity number of 0.95 dl/g and a terminal carboxyl group concentration of 10 equivalents/ton. This polymer is designated as "PET-c".

Reference Example 4

production of polyethylene terephthalate (PET-d)

A polyethylene terephthalate polymer having an intrinsic viscosity number of 0.64 dl/g and a terminal carboxyl group concentration of 17 equivalents/ton was obtained in the same manner as in Reference Example 1 except that the amount of phenylphosphonic acid was changed to 5 mmol%. This polymer is designated as "PET-d".

Reference Example 5

production of polyethylene terephthalate (PET-e)

A polyethylene terephthalate polymer having an intrinsic viscosity number of 0.64 dl/g and a terminal carboxyl group concentration of 17 equivalents/ton was obtained in the same manner as in Reference Example 1 except that the amount of phenylphosphonic acid was changed to 100 mmol%. This polymer is designated as "PET-e".

Reference Example 6

production of polyethylene terephthalate (PET-f)

A polyethylene terephthalate polymer having an intrinsic viscosity number of 0.64 dl/g and a terminal carboxyl group concentration of 17 equivalents/ton was obtained in the same manner as in Reference Example 1 except that the phosphorus compound was changed to phenylphosphinic acid. This polymer is designated as "PET-f".

Reference Example 7

production of polyethylene terephthalate (PET-g)

A polyethylene terephthalate polymer having an intrinsic viscosity number of 0.64 dl/g and a terminal carboxyl group concentration of 17 equivalents/ton was obtained in the same manner as in Reference Example 1 except that the phosphorus compound was changed to orthophosphoric acid. This polymer is designated as "PET-g".

Reference Example 8

production of polyethylene terephthalate (PET-h)

A polyethylene terephthalate polymer having an intrinsic viscosity number of 0.64 dl/g and a terminal carboxyl group concentration of 17 equivalents/ton was obtained in the same manner as in Reference Example 1 except that the phosphorus compound was changed to phosphorous acid. This polymer is designated as "PET-h".

Reference Example 9

production of polyethylene terephthalate (PET-i)

Both antimony oxide and titanium acetate were used as polycondensation catalysts. The amounts of these compounds and phenylphosphonic acid (based on the number of moles of dimethyl terephthalate) are shown in Table 1. A polymer was obtained in the same manner as in Reference Example 1 except these. After this polymer was pre-dried at 150˚C to 160˚C for 3 hours, the solid-phase polymerization of the polymer was carried out in a nitrogen gas atmosphere at 210˚C and 100 Torr for 5 hours. The obtained polymer had an intrinsic viscosity number of 0.74 dl/g and a terminal carboxyl group concentration of 8 equivalents/ton. This polymer is designated as "PET-i".

Reference Example 10

production of polyethylene terephthalate (PET-j)

Tetrabutyl-n-titanate as a transesterification catalyst, germanium oxide as a polycondensation catalyst and orthophosphoric acid as the phosphorus compound were used. The amounts of these compounds (based on the number of moles of dimethyl terephthalate) are shown in Table 1. A polymer was obtained in the same manner as in Reference Example 1 except these. After this polymer was pre-dried at 150˚C to 160˚C for 3 hours, the solid-phase polymerization of the polymer was carried out in a nitrogen gas atmosphere at 210˚C and 100 Torr for 5 hours. The obtained polymer had an intrinsic viscosity number of 0.74 dl/g and a terminal carboxyl group concentration of 8 equivalents/ton. This polymer is designated as "PET-j".

Example 1

After PET-a was dried at 180˚C with a rotary vacuum drier for 3 hours, it was supplied into an extruder to be

melt extruded into a sheet form from a slit die at 280˚C. This sheet was solidified by cooling with a cooling drum having a surface temperature of 20˚C to obtain an unstretched film. This film was stretched to 3.5 times in the longitudinal direction at 100˚C, cooled with 25˚C rolls, and guided into a tenter while both ends of the film were held by a clip to be stretched to 3.7 times in the transverse direction in an atmosphere heated at 130˚C. Thereafter, it was heat set in an atmosphere heated at 220˚C in the tenter, shrunk by 3 % in the transverse direction and cooled to room temperature so as to obtain a polyester film. The evaluation results of the melt extrudability, film formability and other characteristic properties of the obtained film in the film forming process are shown in Table 2.

Example 2

The procedure of Example 1 was repeated except that PET-b was used in place of PET-a. The evaluation results are shown in Table 2.

Comparative Example 1

A polyester film was obtained in the same manner as in Example 1 except that the drying temperature of the polyester raw material was changed to 170˚C and the melt extrusion temperature was changed to 290˚C. The characteristic properties of the obtained film are shown in Table 2.

Comparative Example 2

The procedure of Example 1 was repeated except that PET-c was used in place of PET-a. The evaluation results are shown in Table 2.

Example 3

A polyester film was obtained in the same manner as in Example 1 except that the draw ratio in the longitudinal direction was changed to 3.3 times and the draw ratio in the transverse direction was changed to 3.5 times. The characteristic properties of the obtained film are shown in Table 2.

Comparative Example 3

A polyester film was obtained in the same manner as in Example 1 except that the draw ratio in the longitudinal direction was changed to 2. 9 times and the draw ratio in the transverse direction was changed to 3.0 times. The characteristic properties of the obtained film are shown in Table 2.

Comparative Example 4

A polyester film was obtained in the same manner as in Example 1 except that the draw ratio in the longitudinal direction was changed to 4.0 times and the draw ratio in the transverse direction was changed to 4.2 times. The characteristic properties of the obtained film are shown in Table 2.

Comparative Example 5

The procedure of Example 1 was repeated except that PET-d was used in place of PET-a. The evaluation results are shown in Table 2.

Comparative Example 6

The procedure of Example 1 was repeated except that PET-e was used in place of PET-a. The evaluation results are shown in Table 2.

Example 4

The procedure of Example 1 was repeated except that PET-f was used in place of PET-a. The evaluation results are shown in Table 2.

Example 5

The procedure of Example 1 was repeated except that PET-i was used in place of PET-a. The evaluation results are shown in Table 2.

Comparative Example 7

The procedure of Example 1 was repeated except that PET-g was used in place of PET-a. The evaluation results are shown in Table 2.

Comparative Example 8

The procedure of Example 1 was repeated except that PET-h was used in place of PET-a. The evaluation results are shown in Table 2.

Comparative Example 9

The procedure of Example 1 was repeated except that PET-j was used in place of PET-a. The evaluation results are shown in Table 2.

Table 1

| | Polyester raw material | | | | | | | |
|---|---|---|---|---|---|---|---|---|
| | Type | Intrinsic viscosity number (dl/g) | Metal elements added as catalysts (mmol%) | | | | Phosphoric acid compounds | |
| | | | Mn | Sb | Ti | Ge | Type | Amount (mmol%) |
| Reference Example 1 | PET-a | 0.64 | 30 | 20 | - | - | Phenylphosphonic acid | 50 |
| Reference Example 2 | PET-b | 0.82 | 30 | 20 | - | - | Phenylphosphonic acid | 50 |
| Reference Example 3 | PET-c | 0.95 | 30 | 20 | - | - | Phenylphosphonic acid | 50 |
| Reference Example 4 | PET-d | 0.64 | 30 | 20 | - | - | Phenylphosphonic acid | 5 |
| Reference Example 5 | PET-e | 0.64 | 30 | 20 | - | - | Phenylphosphonic acid | 100 |
| Reference Example 6 | PET-f | 0.64 | 30 | 20 | - | - | Phenylphosphonic acid | 50 |
| Reference Example 7 | PET-g | 0.64 | 30 | 20 | - | - | Orthophosphoric acid | 50 |
| Reference Example 8 | PET-h | 0.64 | 30 | 20 | - | - | Phosphorous acid | 50 |
| Reference Example 9 | PET-i | 0.74 | 15 | 25 | 3 | - | Phenylphosphonic acid | 20 |
| Reference Example 10 | PET-j | 0.74 | - | - | 5 | 30 | Orthophosphoric acid | 50 |
| *Ti in Reference Example 10 means the elemental titanium of a titanium compound added as a transesterification reaction catalyst. | | | | | | | | |

Table 2

| | Extrudability | Film formability | Characteristic properties of film | | | |
|---|---|---|---|---|---|---|
| | | | Intrinsic viscosity number (dl/g) | Terminal carboxyl group concentration (equivalents/ton) | Plane orientation coefficient "fn" | Hydrolysis resistance |
| Example 1 | ○ | ○ | 0.58 | 22 | 0.171 | ○ |
| Example 2 | ○ | ○ | 0.70 | 17 | 0.174 | ◎ |
| C.Ex. 1 | ○ | ○ | 0.52 | 40 | 0.171 | × |
| C.Ex. 2 | × | ○ | 0.79 | 25 | 0.174 | ◎ |
| Example 3 | ○ | ○ | 0.58 | 22 | 0.163 | △ |
| C.Ex. 3 | ○ | ○ | 0.58 | 22 | 0.158 | × |
| C.Ex. 4 | ○ | Δ | 0.58 | 22 | 0.177 | ○ |
| C.Ex. 5 | ○ | ○ | 0.58 | 22 | 0.167 | × |
| C.Ex. 6 | ○ | ○ | 0.58 | 22 | 0.175 | Δ |
| Example 4 | ○ | ○ | 0.58 | 22 | 0.171 | ○ |
| C.Ex. 7 | ○ | ○ | 0.58 | 30 | 0.165 | × |
| C.Ex. 8 | ○ | ○ | 0.58 | 30 | 0.165 | × |
| Example 5 | ○ | ○ | 0.65 | 15 | o.173 | ○ |
| C.Ex. 9 | ○ | ○ | 0.65 | 15 | 0.173 | × |
| C.Ex.: Comparative Example | | | | | | |

As described above, according to the present invention, firstly, there can be provided a biaxially oriented polyester film for solar cells which rarely deteriorates in mechanical properties and has excellent hydrolysis resistance even when it is used in a high-temperature high-humidity harsh natural environment for a long time. According to the present invention, secondly, there can be provided a biaxially oriented polyester film for solar cells which has excellent hydrolysis resistance without using a hydrolysis resisting agent such as a carbodiimide compound or an oxazoline compound.

The biaxially oriented polyester film for solar cells of the present invention can be advantageously used as a film member constituting a solar cell, especially a rear surface protective film for solar cells.

## Claims

1. A biaxially oriented polyester film for solar cells which is made of a composition comprising a polyethylene terephthalate prepared by using an antimony compound and/or a titanium compound as a polycondensation catalyst(s), wherein
the composition contains 10 to 80 mmol% of a phosphorus atom derived from a phosphorus compound represented by the following formula (I) or (II) and 2 to 60 mmol% of the total of an antimony atom and/or a titanium atom in terms of metal atoms based on the moles of all dicarboxylic acid components constituting the polyethylene terephthalate, the biaxially oriented polyester film has a plane orientation coefficient "fn" of 0.160 to 0.175, and the polyester of the film has an intrinsic viscosity number of 0.56 to 0.74 dl/g and a terminal carboxyl group concentration of 6 to 29 equivalents/ton.

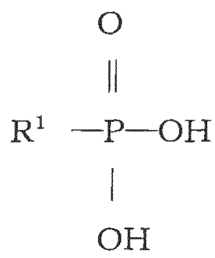

(I)

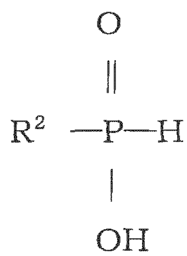

(II)

(wherein, each of $R^1$ and $R^2$ is independently an alkyl group having 1 to 6 carbon atoms, aryl group or benzyl group.)

**2.** The biaxially oriented polyester film according to claim 1, wherein the phosphorus compound represented by the formula (I) is methylphosphonic acid, ethylphosphonic acid, propylphosphoic acid, isopropylphosphonic acid, butylphosphonic acid, phenylphosphonic acid, tolylphosphonic acid, xylylphosphonic acid or benzylphosphonic acid.

**3.** The biaxially oriented polyester film according to claim 1, wherein the phosphorus compound represented by the formula (II) is methylphosphinic acid, ethylphosphinic acid, propylphosphinic acid, isopropylphosphinic acid, butylphosphinic acid, phenylphosphinic acid, tolylphosphinic acid, xylylphosphinic acid or benzylphosphinic acid.

**4.** The biaxially oriented polyester film for solar cells according to claim 1, wherein the phosphorus compound is phenylphosphonic acid.

**5.** A solar cell protective film which comprises the biaxially oriented polyester film for solar cells of claim 1.

**6.** Use of the biaxially oriented polyester film for solar cells of claim 1 as a solar cell protective film.

**INTERNATIONAL SEARCH REPORT**

International application No.
PCT/JP2010/057198

A. CLASSIFICATION OF SUBJECT MATTER
*C08J5/18*(2006.01)i, *H01L31/042*(2006.01)i

According to International Patent Classification (IPC) or to both national classification and IPC

B. FIELDS SEARCHED

Minimum documentation searched (classification system followed by classification symbols)
C08J5/00-5/02, C08J5/12-5/22, B29C47/00-47/96, B29C55/00-55/30, B29C61/00-61/10, B32B1/00-35/00, H01L31/04-31/06

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2010 |
| Kokai Jitsuyo Shinan Koho | 1971-2010 | Toroku Jitsuyo Shinan Koho | 1994-2010 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y | JP 2008-066629 A (Toppan Printing Co., Ltd.), 21 March 2008 (21.03.2008), claims; paragraph [0041] (Family: none) | 1-6 |
| Y | JP 2007-276478 A (Mitsubishi Polyester Film GmbH), 25 October 2007 (25.10.2007), claims; paragraphs [0052], [0081] & US 2007/0237972 A1 & EP 1842662 A1 & DE 102006016156 A & KR 10-2007-0100165 A | 1-6 |
| Y | JP 2004-269772 A (Konica Minolta Holdings, Inc.), 30 September 2004 (30.09.2004), claims; paragraphs [0001], [0055], [0062] (Family: none) | 1-6 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 17 May, 2010 (17.05.10) | 25 May, 2010 (25.05.10) |

| Name and mailing address of the ISA/ | Authorized officer |
|---|---|
| Japanese Patent Office | |
| Facsimile No. | Telephone No. |

Form PCT/ISA/210 (second sheet) (July 2009)

**INTERNATIONAL SEARCH REPORT**

International application No.
PCT/JP2010/057198

C (Continuation). DOCUMENTS CONSIDERED TO BE RELEVANT

| Category* | Citation of document, with indication, where appropriate, of the relevant passages | Relevant to claim No. |
|---|---|---|
| Y | JP 2007-070430 A (Toray Industries, Inc.), 22 March 2007 (22.03.2007), claims (Family: none) | 1-6 |
| Y | JP 2006-341425 A (Toyobo Co., Ltd.), 21 December 2006 (21.12.2006), claims; paragraphs [0001], [0021], [0041] (Family: none) | 1-6 |
| P,X | JP 2009-256621 A (Mitsubishi Plastics, Inc.), 05 November 2009 (05.11.2009), claims; paragraphs [0012] to [0015], [0032] (Family: none) | 1-6 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2007302878 A
- JP 2002187965 A
- JP 2002026354 A
- JP 2002100788 A
- JP 2002134770 A
- JP 2002134771 A
- JP 2007007885 A
- JP 2006306910 A
- JP 57057628 A
- JP 1275031 A